(19)

Europäisches
Patentamt
European
Patent Office
Office européen
des brevets

(11) **EP 2 509 216 A1**

(12) **EUROPEAN PATENT APPLICATION**

(43) Date of publication:
**10.10.2012 Bulletin 2012/41**

(51) Int Cl.:
*H03F 1/32* (2006.01)   *H03F 3/50* (2006.01)
*H03F 1/30* (2006.01)

(21) Application number: **11290179.8**

(22) Date of filing: **07.04.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **NXP B.V.**
**5656 AG Eindhoven (NL)**

(72) Inventors:
• **Marie, Herve**
  **14906 Caen Cedex (FR)**

• **Crinon, Guillaume**
  **14906 Caen Cedex (FR)**
• **Constantinidis, Nicolas**
  **14906 Caen Cedex (FR)**

(74) Representative: **Krott, Michel et al**
**Intellectual Property and Licensing**
**NXP Semiconductors**
**High Tech Campus 60**
**5656 AG Eindhoven (NL)**

(54) **Buffer circuit with high linearity**

(57) Methods, devices and systems are provided for use with or in connection with circuits providing buffering. According to one such device, a buffer circuit includes a transistor (106) with a base, a collector and an emitter and the transistor is configured as a common emitter. An input (104) to the buffer circuit is connected to the base of the transistor. A variable current source (108) provides current to the emitter of the transistor. An output (110) of the buffer circuit is connected to the emitter of the buffer transistor. A cancellation circuit (108) is configured and arranged to counteract variations in emitter current by adjusting the current provided by the variable current source to the emitter of the buffer transistor.

FIG. 1

EP 2 509 216 A1

**Description**

Aspects of the present disclosure are directed toward a buffer circuit with high-speed and good linearity. In certain embodiments, the buffer circuit operates by dampening or counteracting variations of emitter current.

Analog signal processing is an important aspect of many different applications. A particularly demanding area is the high-speed communication environment. This includes wireless and wired communications. Processing in the analog realm can involve filtering, signal shaping and various other modifications. Thus, it is sometimes desirable to buffer the analog signal as part of the processing. It can be beneficial to provide this buffering while distorting the signal as little as possible.

High-bandwidth, high-linearity ADCs are desirable components of systems, such as wireless base-stations subsystems. Moreover, it is sometimes beneficial to perform the filtering, separation, decoding and processing of the aggregated communication signals received by each sector antenna in the digital domain. This can, for example, provide flexibility in the design or operation of the system. For such systems, it can be desirable for the signal path between the antenna and the digital processors to be as clean as possible.

Providing such benefits often comes at the expense of high power consumption. For many applications, however, there is a desire to reduce the power consumption. For instance, silicon integration of functions achieved today by separate components (e.g., down-mixing, filtering, programmable gain, buffering and/or analog-to-digital conversion) can be facilitated if the power consumption of the components can be a common low voltage and low power consumption.

A buffer circuit can also be specifically designed for a particular load. This helps the buffer operation when the load matches the design specifications. For instance, a feed forward concept can use a dummy load that determines undesirable properties of the filter circuit can be dampened or counteracted. However, the operation of the buffer can vary significantly if the load varies or does not match the original design specifications. Thus, the dummy load may not accurately model the true load.

Aspects of the present disclosure are directed toward a buffer circuit that addresses one or more of such buffer-design considerations.

Embodiments of the present disclosure relate to a buffer circuit. The buffer circuit includes a transistor with a base, a collector and an emitter and is configured as a common emitter. An input to the buffer circuit is connected to the base of the transistor. A variable current source provides current to th*e emitter of the transistor. An output of the buffer circuit is connected to the emitter of the buffer transistor. A cancellation circuit is configured and arranged to counteract variations in the emitter current by adjusting the current provided by the variable current source to the emitter of the buffer transistor.

According to other embodiments of the present disclosure, a method is provided for operating a buffer circuit to generate an output signal from an input signal. The method includes receiving the input signal at a base of a buffer transistor. The method also includes generating, in response to the input signal, the output signal at the emitter of the buffer transistor by enabling the buffer transistor to allow current from a current source to flow between a collector of the buffer transistor and the emitter of the buffer transistor. The buffer circuit is used to detect current in the collector of the buffer transistor. A control signal is generated in response to the detected current, and an amount of current provided by the current source is adjusted in response to the control signal.

The above discussion is not intended to describe each embodiment or every implementation. The figures and following description also explicitly describe various embodiments and other embodiments, modifications, equivalents, and alternatives fall within the spirit and scope of the disclosure.

Various example embodiments may be more completely understood in consideration of the following detailed description in connection with the accompanying drawings, in which:

FIG. 1 depicts a block diagram for a buffer device, consistent with embodiments of the present disclosure;
FIG. 2 depicts a circuit diagram for a buffer device designed to cancel collector current, consistent with an embodiment of the present disclosure;
FIG. 3 depicts a buffer circuit at the transistor level, consistent with embodiments of the present disclosure; and
FIG. 4 depicts another buffer circuit at the transistor level, consistent with embodiments of the present disclosure.

While the disclosure is amenable to various modifications and alternative forms, examples thereof have been shown by way of example in the drawings and will be described in detail. It should be understood, however, that the intention is not to limit the disclosure to the particular embodiments shown and/or described. On the contrary, the intention is to cover all modifications, equivalents, and alternatives falling within the spirit and scope of the disclosure.

The various disclosed embodiments are believed to be applicable to a variety of different types of processes, devices, and arrangements for use with various different systems and devices. While the embodiments are not necessarily so limited, various aspects of the disclosure may be appreciated through a discussion of examples using this context.

Consistent with an embodiment of the present disclosure, a buffer circuit is provided. The buffer circuit includes a transistor with a base, a collector and an emitter. An input to the buffer circuit is connected to the base of the transistor. A variable current source provides current to the emitter of the transistor. An output of the buffer circuit is connected to the emitter of the buffer transistor. A cancellation circuit is configured and arranged to dampen or counteract variations in emitter current by adjusting the current provided by the variable current source to the emitter of the buffer transistor. In certain instances, the dampening effect can be accomplished by adjusting the variable current source in response to current variation detected at the collector of the buffer transistor and thereby maintaining the current at the emitter of the buffer transistor at a relatively constant value.

According to a certain embodiments of the present disclosure, a circuit is used to monitor variations in the collector current. For instance, a resistive element R placed in series with the collector of the buffer transistor generates a voltage according to the collector current ($I_c$), where the voltage = $R*I_c$. This generated voltage can then be compared a reference value (e.g., a DC voltage) to generate a control signal that is provided to control the amount of current provided by the variable current source. In certain instances, the generated control signal can be generated using a comparator (or similar circuit) with a given gain. Thus, the control signal represents a multiple (e.g., the comparator gain) of the difference between the reference voltage and the voltage generated by the monitoring circuit.

Aspects of the present disclosure recognize that the variable current source can be selected such that it provides the majority of the current to the output/load. Thus only a small proportion of current comes from the emitter of T1. This creates a feedback loop that compares Ic*R with a (DC) reference voltage and thereby maintains the current of the emitter of T1 at constant value.

Various embodiments of the present disclosure can be particularly useful for providing a buffer that functions as an architecture that is closed-loop and has wide-band functionality (*e.g.*, gain bandwidth on the order of 10-15 GHz or even higher). Embodiments can also be useful for providing a buffer with good linearity, low noise, high input impedance, low output impedance and good isolation. Certain embodiments can also be useful for their low-power usage. Moreover, various embodiments of the present disclosure can be useful for driving varying loads, used in analog-to-digital converters (ADCs) or as part of filters. It has been recognized that various embodiments can be useful for these and other applications in which it is desirable for the circuit to not be calibrated for a particular load, e.g., not requiring the use of a dummy load that is calibrated for a particular load value. In this manner, embodiments allow for a wide range of varying loads and thereby facilitate use in a variety of different systems and environments.

Embodiments of the present disclosure are directed toward a follower circuit having a main transistor that is linearized by cancelling variations in its emitter current using a wideband feedback loop. For instance, a wideband feedback system can modulate the main transistor current source in a manner that dampens or counteracts variations in the main transistor's emitter current. In certain instances, a feedback amplifier can be made wideband by introducing a zero in the open-loop transfer function. This zero can be adjustable (e.g., using an appropriate capacitor value). Feed-through current sources allow the loop gain to be maintained while operating at a low supply voltage. While these and other potentially useful attributes are not necessarily required for all embodiments, these aspects will be understood in the context of one or more embodiments discussed herein.

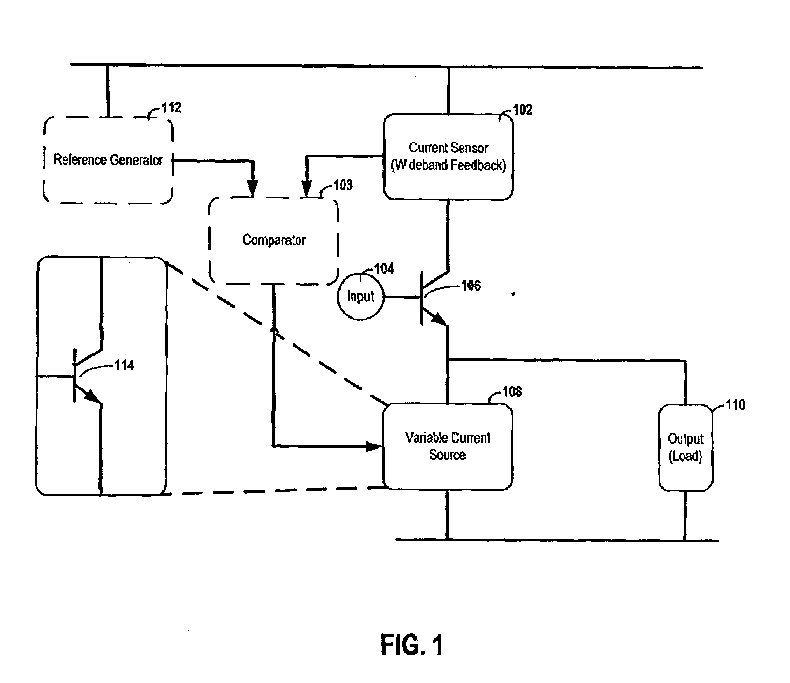

FIG. 1 depicts a block diagram for a buffer device, consistent with embodiments of the present disclosure. Transistor 106 operates as a buffer for input signal 104 by driving output (load) 110 in response to the input signal 104. Current sensor 102 detects current passing through the collector of transistor 106. This detected current is then used as an input to variable current source 108. Variable current source 108 dampens or counteracts variations of current in the emitter by adjusting the amount of current generated by current source 108. In certain instances, the dampening effect can be accomplished by adjusting the variable current source in response to current variation detected at the collector of the buffer transistor and thereby maintaining the current at the emitter of the buffer transistor at a relatively constant value.

According to some embodiments of the present disclosure, the variable current source can be configured using a transistor 114 by providing the output of the current sensor 102 to the base of the transistor 114.

Consistent with embodiments of the present disclosure, the current sensor 102 can be implemented by comparing the sensed current to a reference voltage. The result of the comparison can then be provided to the variable current source 108.

According to embodiments of the present disclosure, a comparator 103 can be used in conjunction with a reference generator 112. The comparator 103 compares the output of the current sensor 102 to a reference (voltage or current) provided by reference generator 112. The use of comparator 103 and reference generator 112 allows control of the variable current source to relative to the reference provided by reference generator 112. Moreover, reference generator 112 can provide gain functions relative to the output of current sensor 102.

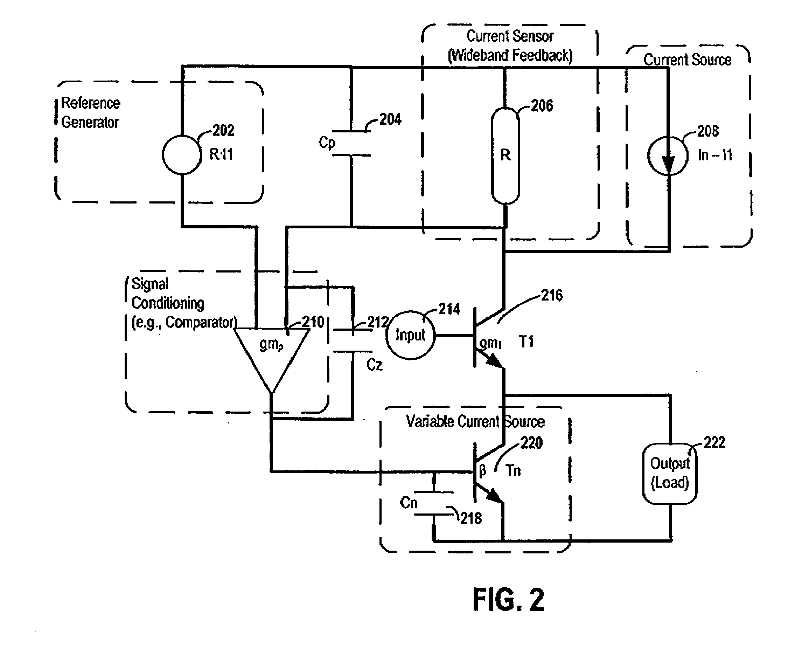

FIG. 2 depicts a circuit diagram for a buffer device designed to cancel emitter current, consistent with an embodiment of the present disclosure. Transistor T1/216 operates as a buffer by driving output (load) 222 in response to input signal 214. Element 206 detects the amount of collector current in transistor 216 to provide a signal to amplifier 210. Element 202 generates a reference voltage to be provided to amplifier 210. Amplifier 210 uses the reference voltage and the collector current-based signal as inputs to provide an amplified output to transistor Tn/220. Transistor 220 counteracts variations in detected collector current and thereby affects the output seen by load 222 by maintaining the emitter current at a relatively constant value.

Current source 208 provides current to the collector of transistor T1/216. This current source 208 can be particularly useful for improving the properties of the buffer device. For instance, current source 208 can facilitate the use of a high load resistor on the collector of T1, and thus provide a higher loop gain.

According to certain embodiments of the present disclosure, a zero can be added to the open-loop transfer function of the buffer device using, for example, capacitor Cz/212. This can be particularly useful for providing a wideband response from the buffer device. The value of the zero can be set according to a desired gain bandwidth product and for a particularly high range of frequencies.

Capacitances Cp/204 and Cn/218 represent capacitance values that can affect the transfer function of the buffer device. These values can include, but are not limited to, the total capacitance of various elements of the buffer device. These values can also include discrete capacitive components.

Consistent with embodiments of the present disclosure, the early voltage (Vea) of transistor T1 can limit the performance of the buffer device because the collector current II also depends on the Vcb voltage:

$$H_3 = \frac{1}{4}.V_T.\left(\frac{1}{G.I_1.Z_L} + \frac{1}{V_{EA}}\right)^3 \left(\frac{V_T}{2}.\left(\frac{1}{G.I_1.Z_L} + \frac{1}{V_{EA}}\right) - \frac{1}{3}\right).V_{in}^2$$

The components of the buffer and their values can be selected according to the desired buffer device characteristics. For instance, the finite loop range and distortion in the feedback path can be considered. As one example, the introduction of a zero (e.g., using capacitor 212) can increase the bandwidth and facilitate buffering of high frequencies:

$$z_1 = \frac{gm_p}{C_z}$$

$$z_2 = \frac{1}{R.C_p}$$

$$p_1 = \frac{gm_n}{\beta.\left(C_n + C_z.\left(1 - R.gm_p\right)\right)}$$

$$p_2 = \frac{1}{R.\left(C_p + \frac{C_z.C_n}{C_z + C_n}\right)}$$

$$p_2' = \frac{C_n + C_z.\left(1 - R.gm_p\right)}{R.\left(C_p.C_z + C_z.C_n + C_p.C_n\right)}$$

$$p_3 = \frac{gm_1}{C_L}$$

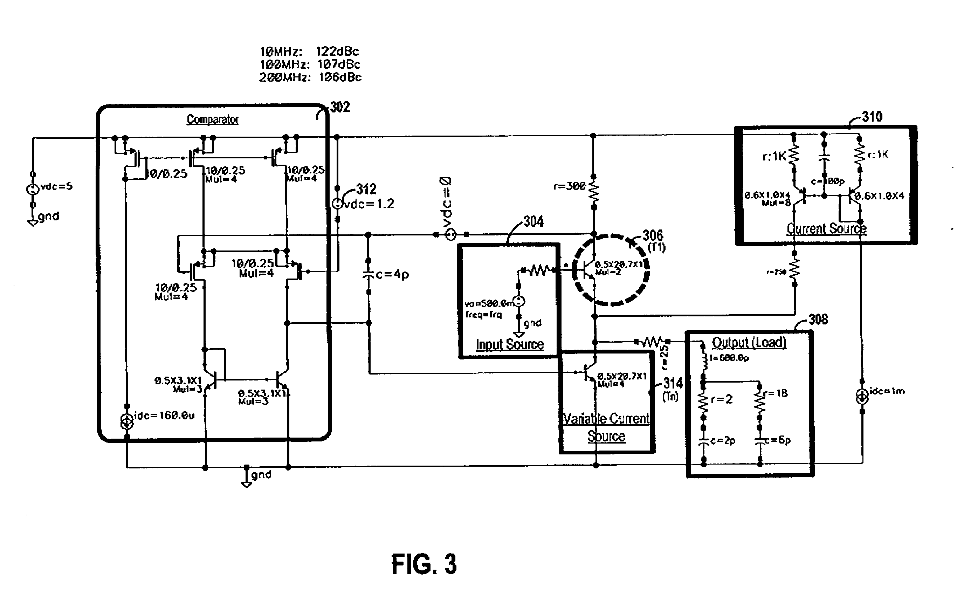

FIG. 3 depicts a buffer circuit at the transistor level, consistent with embodiments of the present disclosure. The transistor T1/306 operates as an input buffer to generate an output signal seen on output (load) 308 in response to an input signal received from input source 304. Transistor Tn/314 counteracts emitter current in transistor T1/306 in response to amplifier circuit 302 detecting current in the collector. Voltage reference generator 312 -provides a reference point for amplifier circuit 302. Amplifier circuit 302 provides the variable current source 314 with an output that is responsive to the comparison. Current source 310 provides current to the output of the transistor T1.

The load and input sources are presented for illustration and with reference to the experimentally determined buffer characteristics listed on FIG. 3 (e.g., 10Mhz: 122dBc; 100MHz: 107dBc; and 200MHz: 106dBc). The actual input sources and loads could be different depending upon the desired application.

The specific component values are also relevant to the above experimentally determined characteristics, however, these specific values are not limiting. For instance, the values for the passive components (e.g., resistors, capacitors and inductors) can be set according to the desired performance. In other instances, the transistor specifications can be adjusted.

Various other modifications could be made to the circuit without departing from the spirit of the present disclosure. For instance, the design could be implemented using bipolar, CMOS and/or BiCMOS processes.

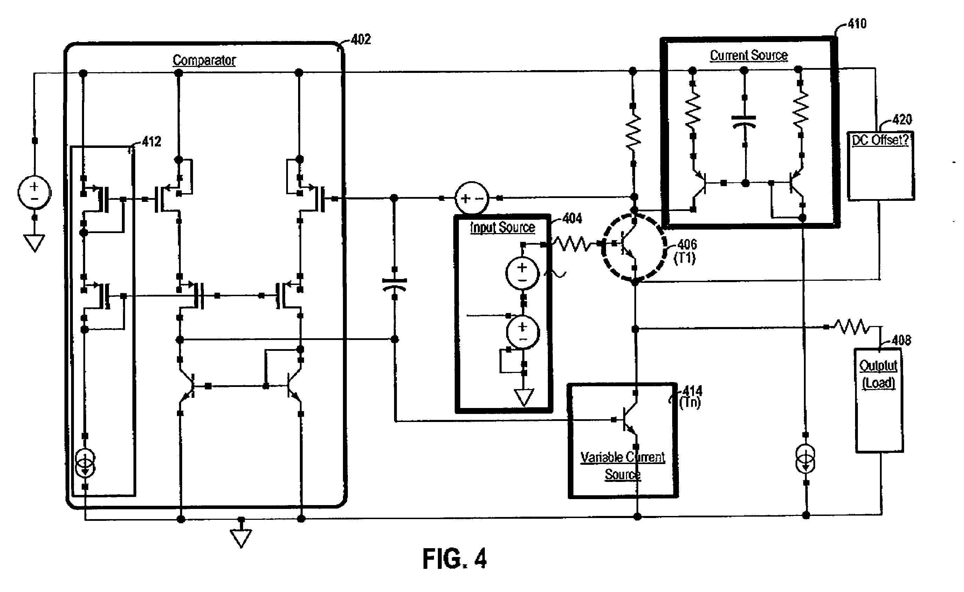

FIG. 4 depicts another buffer circuit at the transistor level, consistent with embodiments of the present disclosure. The circuit of FIG. 4 provides basic functionality similar to that discussed in connection with FIG. 3. For instance, the transistor T11406 operates as an input buffer to generate an output signal seen on output (load) 408 in response to an input signal received from input source 404. Transistor Tn/414 counteracts emitter current in transistor T1/406 in response to amplifier circuit 402 detecting this current. Voltage reference generator 412 provides a reference point for amplifier circuit 402. Amplifier circuit 402 provides the variable current source 414 with an output that is responsive to the comparison. Current source 410 provides current to the output of the transistor T1.

Aspects of the circuit of FIG. 4, however, also recognize that the current source can be configured in an alternative manner. Accordingly, the circuit is configured to provide the current from the current source to the collector of the transistor Tn. Aspects of the present disclosure recognize that this configuration can be particularly useful for applications that use a higher load resistor on the collector of T1, and thus provide a higher loop gain.

Consistent with certain embodiments of the present disclosure, a DC offset circuit 420 can provide a DC offset, e.g., relative to a DC component of the input voltage provided to input source 404. The feedback in the base of the buffer transistor can therefore include a DC feedback component with a low cut-off frequency (e.g., ideally 0). This can allow for DC coupling between the buffer and an external system, such as a filter with an ADC or an ADC alone.

According to specific embodiments of the present disclosure, the DC offset circuit 420 compares the buffer output voltage and a DC reference (such as VDD/2 that is taken from an ADC) using an operational amplifier and feedback through a resistor. This comparison is used to provide the proper DC voltage on the base of the buffer transistor. For an ADC, the VDD/2 can be generated from the ADC and used to force the DC voltage of the buffer output to a value of VDD/2. Maintaining the buffer output of the variable current source at VDD/2 can be useful for reducing and/or minimizing harmonic distortion.

Aspects of the present disclosure are directed toward the realization that the various embodiments discussed herein can be implemented using various process techniques including, but not necessarily limited to, bipolar, CMOS and/or BiCMOS.

Aspects of the present disclosure can be particularly useful for high-bandwidth, high-linearity ADCs. Such ADCs have many potential uses and can be key components of wireless base-stations subsystems. The filtering, separation, decoding and processing of the aggregated communication signals received by each sector antenna can be accomplished in the digital domain, which can allow for more flexibility in the design and operation of the system. For such applications, the signal received by the digital processors should be as undistorted as possible. Thus, the signal path between the antenna and the digital processors has to be as clean as possible and should provide the low noise and high linearity.

According to certain embodiments of the present disclosure, a base-station subsystem has the performance of a receive chain enhanced using buffering of the input to an ADC. This allows isolation of the preceding stage from switching-input impedance and allows a known and constant input impedance to be presented to the ADC. As a consequence, a good input buffer can be particularly useful for addressing such applications.

Aspects of the present invention are directed toward a dedicated base station having an integrated circuit with an input buffer, an analog filter and an ADC. Matching between internal analog frontend and customer external components is facilitated by the use of the input buffer. For instance, an input buffer makes the impedance a known (high) value. Similarly, the output impedance can be a known (low) value.

Various other applications and uses of the embodiments discussed herein are also contemplated. Accordingly, the disclosure is not limited to base stations, wireless devices or similar applications.

Certain embodiments of the present disclosure can be particularly useful for providing a buffer that has been experimentally determined to be able to achieve a third harmonic (H3) rejection higher than 105dBc at 200MHz / 2V peak-to-peak-differential input, driving a capacitive load of 9pF, with a total current of 24mA. Other aspects can be particularly useful for providing input impedances that are very high, since the feedback loop cancels the base and collector currents in T1. The experimental determinations show that an impedance of less than 0.25pF up to about 500MHz can be achieved and that an impedance of 1pF at input signal speeds of up to at least 1 GHz can also be achieved. Still other aspects can be useful for providing output impedances that are low.

Various embodiments are directed toward programmable current biasing. This can be particularly useful for optimizing power consumption with regards to performance and can depend on the load and maximum frequency.

Other aspects of the present disclosure can be particularly useful for providing a buffer capable of driving a wide range of loads within limits set by the biasing current and required linearity. These embodiments can provide such operation without the need for matching the load with internal components, nor a need for calibrating the circuit against a particular load.

Based upon the above discussion and illustrations, those skilled in the art will readily recognize that various modifications and changes may be made without strictly following the exemplary embodiments and applications illustrated and described herein. For example, the voltage levels and specific circuits are provided by way of example and are not necessarily limiting. Such modifications do not depart from the true spirit and scope of the present disclosure, including that set forth in the following claims.

## Claims

1. A buffer circuit comprising:

   - a buffer transistor (106) having a base, a collector and an emitter and being configured as a common emitter;
   - an input (104) to the buffer circuit that is connected to the base of the buffer transistor;
   - a variable current source (108) providing current to the emitter of the buffer transistor;
   - an output (110) of the buffer circuit that is connected to the emitter of the buffer transistor; and
   - a cancellation circuit (108) configured and arranged to counteract variations in emitter current by adjusting the current provided by the variable current source to the emitter of the buffer transistor.

2. The buffer circuit of claim 1, wherein the cancellation circuit includes a current sensing circuit configured to sense current in the collector of the buffer transistor.

3. The buffer circuit of claim 1, wherein the cancellation circuit includes a current sensing circuit configured to sense current in the collector of the buffer transistor and the variable current source includes a cancellation transistor configured to respond to the current sensing circuit by adjusting the current provided to the emitter of the buffer transistor.

4. The buffer circuit of claim 1, wherein the cancellation circuit includes a current sensing resistor configured to generate a voltage drop that is responsive to the current in the collector.

5. The buffer circuit of claim 1, wherein the input impedance of the buffer circuit is less than about 1pFat input signal speeds of up to at least 1GHz.

6. The buffer circuit of claim 1, further including an impedance element configured and arranged to introduce a zero into an open-loop transfer function of the buffer circuit.

7. The buffer circuit of claim 1, wherein the cancellation circuit includes a current sensing circuit configured to sense current in the collector of the buffer transistor and an amplifier for amplifying an output of the current sensor.

8. The buffer circuit of claim 1, wherein the buffer transistor is a bipolar junction transistor.

9. The buffer circuit of claim 1, wherein the buffer circuit provides 105dBc at input signals at speeds of 200MHz and voltages of 2V peak-to-peak-differential input, while driving a capacitive load of 9pF and has a total current of 24mA.

10. A method for operating a buffer circuit to generate an output signal from an input signal, the method comprising:

   - receiving the input signal (104) at a base of a buffer transistor (106);
   - generating, in response to the input signal, the output signal (110) at the emitter of the buffer transistor by enabling the buffer transistor (106) to allow current from a current source (108) to flow between a collector of the buffer transistor and the emitter of the buffer transistor;
   - detecting (102) current in the collector of the buffer transistor;
   - generating (103) a control signal in response to the detected current; and
   - adjusting an amount of current provided by the current source (108) in response to the control signal.

11. The method of claim 11, wherein the step of adjusting the amount of current includes changing the voltage on a gate of a current source transistor in response to the control signal.

12. The method of claim 11, wherein the step of generating the output signal is accomplished by providing 105dBc at input signal speeds of 20OMHz and voltages at 2V peak-to-peak-differential input, while driving a capacitive load of 9pF and with a total current of 24mA.

13. The method of claim 11, wherein the step of receiving the input signal at a base of a buffer transistor is accomplished while providing an input impedance of less than 0,25pF at input signal speeds up to 500MHz.

14. The method of claim 11, wherein the buffer transistor is a bipolar junction transistor.

15. The method of claim 11, wherein the step of generating an output signal is accomplished according to one or more of the following conditions, at signal speeds of 10Mhz: 122dBc; at signal speeds of 100MHz: 107dBc; and at signal speeds of 200MHz: 106dBc.

FIG. 1

EP 2 509 216 A1

FIG. 2

FIG. 3

**FIG. 4**

Europäisches
Patentamt

European
Patent Office

Office européen
des brevets

# EUROPEAN SEARCH REPORT

Application Number

EP 11 29 0179

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/164133 A1 (FUKUI EIZO [JP] ET AL) 27 July 2006 (2006-07-27) * paragraphs [0040] - [0124]; figures 1-8 * ----- | 1-15 | INV. H03F1/32 H03F3/50 H03F1/30 |
| X | US 4 573 021 A (WIDLAR ROBERT J [MX]) 25 February 1986 (1986-02-25) * column 3, line 58 - column 8, line 48; figures 2-4 * ----- | 1-15 | |
| X | SHIN H J: "A SELF-BIASED FEEDBACK-CONTROLLED PULL-DOWN EMITTER FOLLOWER FOR HIGH-SPEED LOW-POWER BIPOLAR LOGIC CIRCUITS", IEICE TRANSACTIONS ON ELECTRONICS, INSTITUTE OF ELECTRONICS, TOKYO, JP, vol. E77-C, no. 5, 1 May 1994 (1994-05-01) , pages 853-858, XP000459526, ISSN: 0916-8524 * page 855, left-hand column, line 4 - page 855, right-hand column, line 4; figure 4 * ----- | 1-3,8, 10,11,14 | |

TECHNICAL FIELDS
SEARCHED (IPC)

H03F
H03K

The present search report has been drawn up for all claims

| Place of search | Date of completion of the search | Examiner |
|---|---|---|
| The Hague | 27 July 2011 | Fedi, Giulio |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 2 509 216 A1**

## ANNEX TO THE EUROPEAN SEARCH REPORT
## ON EUROPEAN PATENT APPLICATION NO.

EP 11 29 0179

This annex lists the patent family members relating to the patent documents cited in the above-mentioned European search report.
The members are as contained in the European Patent Office EDP file on
The European Patent Office is in no way liable for these particulars which are merely given for the purpose of information.

27-07-2011

| Patent document cited in search report | | Publication date | Patent family member(s) | | Publication date |
|---|---|---|---|---|---|
| US 2006164133 | A1 | 27-07-2006 | JP<br>JP | 3885073 B2<br>2006042232 A | 21-02-2007<br>09-02-2006 |
| US 4573021 | A | 25-02-1986 | NONE | | |

EPO FORM P0459

For more details about this annex : see Official Journal of the European Patent Office, No. 12/82

13